# EUROPEAN PATENT APPLICATION

(11) **EP 2 037 721 A1**
(43) Date of publication of application: **18.03.2009**
(21) Application number: 07745138.3
(22) Date of filing: 13.06.2007
(51) Int. Cl.: H05H 1/46, C23C 16/24, C23C 16/503, H01L 21/31, H01L 31/04

(54) **PLASMA PROCESSING APPARATUS, PLASMA PROCESSING METHOD AND PHOTOELECTRIC CONVERSION ELEMENT**

(30) Priority: 23.06.2006 JP 2006173847; 23.06.2006 JP 2006173848; 23.06.2006 JP 2006173849
(71) Applicant: Sharp Kabushiki Kaisha, Osaka-shi, Osaka 545-8522 (JP)
(72) Inventor: NAKANO, Takanori, Nara 639-0223 (JP); SANNOMIYA, Hitoshi, Osaka-shi, Osaka 546-0033 (JP)
(74) Representative: Müller - Hoffmann & Partner
(86) International application number: PCT/JP2007/061855
(87) International publication number: WO 2007/148569

(57) **Abstract**

In the case of performing at least two plasma processing steps in a common plasma reaction chamber (101), a CW AC power or a pulse-modulated AC power is appropriately selected as a power for plasma processing in each step. Thereby, even in a step where plasma processing conditions are limited due to apparatus configurations, the plasma processing can be performed in more various manners. Further, uniform plasma can be generated between electrodes and a quantity of a power to be supplied between the electrodes can be reduced, by using the pulse-modulated AC power. Thereby, a plasma processing speed can be reduced so that throughput control is facilitated.

## Description

### TECHNICAL FIELD

The invention relates to a plasma processing apparatus, plasma processing method and photoelectric conversion element. Particularly, the invention relates to a plasma processing apparatus provided with a supply unit that supplies a CW (Continuous Waveform) AC power and a pulse-modulated AC power to a common plasma reaction chamber, a plasma processing method performing at least two plasma processing steps using the plasma processing apparatus, and a photoelectric conversion element manufactured by the above method. More specifically, the invention relates to a plasma processing apparatus and method that form at least an i-type amorphous silicon-base photoelectric conversion layer and an i-type crystalline silicon-base photoelectric conversion layer by a plasma CVD (Chemical Vapor Deposition) method, and also relates to a silicon-base thin film photoelectric conversion element.

### BACKGROUND ART

In recent years, silicon-base thin film photoelectric conversion elements that use a thin film containing crystalline silicon such as polycrystalline silicon or microcrystalline silicon have been developed, and a quantity of production thereof has been increased.

The silicon-base thin film photoelectric conversion element has such a feature that a semiconductor film or a metal electrode film is layered on an inexpensive substrate of a large area, using a deposition device such as a plasma CVD apparatus or a sputter device, and then photoelectric conversion cells formed on the same substrate are isolated or connected by a method such as laser patterning so that the element has the possibility of achieving both low cost and high performance of the photoelectric conversion element.

As examples of such photoelectric conversion element, there is a multilayer silicon-base thin film photoelectric conversion element having a structure in which a photoelectric conversion element layer having an amorphous silicon-base thin film as a photoelectric conversion layer and a photoelectric conversion element layer having a crystalline silicon-base thin film of a different band gap as a photoelectric conversion layer in a layered fashion. This multilayer silicon-base thin film photoelectric conversion element has received attention as a photoelectric conversion element having high conversion efficiency.

However, for manufacturing such silicon-base thin film photoelectric conversion elements, it has been required to reduce further a cost of a manufacturing apparatus such as a CVD apparatus that is a primary apparatus for device production, and this is an issue to be addressed for spreading the photoelectric conversion elements on a large scale. Particularly, the plasma CVD apparatus is required to form a plurality of semiconductor layers. In a general method, steps of forming semiconductor layers that require different deposition conditions or different deposition gases are executed in different plasma CVD reaction chambers (deposition chambers), respectively, so that many reaction chambers are required.

In connection with the above plasma CVD deposition steps for the multilayer silicon-base thin film photoelectric conversion element formed of the amorphous silicon-base photoelectric conversion layer and the crystalline silicon-base photoelectric conversion layer, Japanese Patent Laying-Open No. S59-139682 (Patent Document 1) has described the followings. For forming the crystalline silicon-base semiconductor layer, it is preferable to increase a substrate temperature, a supplied electric power and a gas flow rate in formation conditions of the amorphous silicon-base semiconductor layer, and further to increase a hydrogen concentration of a material gas. More specifically, steps of forming these silicon-base semiconductor films are executed under different conditions, respectively. For forming the crystalline silicon-base semiconductor layer, it is necessary to supply a power larger than that for forming the amorphous silicon-base semiconductor layer.

A plasma CVD apparatus for a thin film solar cell has already employed an inline system having a plurality of reaction chambers (which may also be referred simply as "chambers" hereinafter) in a linear fashion or a multi-chamber system having an intermediate chamber at a center and a plurality of reaction chambers arranged around it.

In the inline system, the substrate is transferred along a linear path so that the whole apparatus must be stopped even when only partial maintenance is required. For example, a plasma CVD apparatus for a thin film solar cell employing the inline system includes a plurality of reaction chambers for forming i-type silicon photoelectric conversion layers. These reaction chambers require the maintenance to a higher extent than other portions in the apparatus. This results in a problem that the whole production line is stopped even when it is necessary to maintain only one reaction chamber forming the i-type silicon photoelectric conversion layer.

Conversely, the multi-chamber system is configured to transfer the substrate of the deposition target to each reaction chamber through the intermediate chamber. A movable partition that can keep airtightness is arranged between each reaction chamber and the intermediate chamber. Therefore, even when a problem occurs in a certain reaction chamber, other reactions chambers are available so that stop of the whole production does not occur. In the production apparatus of the multi-chamber system, however, there are multiple paths for transferring the substrate through the intermediate chamber. Therefore, the intermediate chamber unavoidably has complicated mechanical structures. For example, a complicated mechanism is required for transferring the substrate while keeping airtightness between the intermediate chamber and each reaction chamber. This increases an apparatus cost. Also, such a problem arises that the number of the reaction chambers arranged around the intermediate chamber is restricted due to spatial conditions.

In view of the above problems, Japanese Patent Laying-Open No. 2000-252495 (Patent Document 2) has proposed a manufacturing method of a silicon-base thin film photoelectric conversion apparatus characterized in that a p-type semiconductor layer, an i-type crystalline silicon-base photoelectric conversion layer and an n-type semiconductor layer are deposited successively in a common plasma CVD reaction chamber, and the p-type semiconductor layer is deposited with a pressure of 5 Torr (667 Pa) or more kept in the plasma reaction chamber. It is stated that the above method can manufacture a photoelectric conversion apparatus having good performance and quality by a simple apparatus with low cost and high efficiency.

For reducing the apparatus cost by efficiently using the plasma CVD apparatus as described above, it has been attempted to execute different deposition steps in the same plasma reaction chamber. For example, it has been attempted to simplify the apparatus and to improve the use efficiency by forming semiconductor layers of a silicon-base thin film photoelectric conversion element in the same plasma CVD reaction chamber. Similar attempts have been made in the semiconductor film formation steps of the multilayer silicon-base thin film photoelectric conversion element already described.
Patent Document 1: Japanese Patent Laying-Open No. S59-139682
Patent Document 2: Japanese Patent Laying-Open No. 2000-252495

### DISCLOSURE OF THE INVENTION

### PROBLEMS TO BE SOLVED BY THE INVENTION

However, the following problems arise when at least two plasma processing steps are performed in the same plasma reaction chamber. The conventional plasma processing apparatus merely includes power supply means for providing one kind of AC waveform. When at least two plasma processing steps are to be performed in the same plasma reaction chamber, it is impossible to design the apparatus configurations that are suitable for all the steps. There is a problem that the apparatus configurations limit the conditions of plasma processing in at least one step.

At least two plasma processing steps are specifically performed, e.g., in the following cases. For example, two or more plasma CVD steps are performed under different conditions in the same plasma reaction chamber, respectively. Also, there is a case where, for example, a plasma CVD step and a plasma etching step are performed in the same plasma reaction chamber. In these and other cases, two or more plasma processing steps are performed under different conditions in the same plasma reaction chamber, respectively. The following problem arises in these cases.

For depositing and/or etching a thin film, a plasma CVD apparatus or an etching apparatus including parallel plate electrodes is generally used. In this apparatus, a voltage (discharge start voltage) causing glow discharge between the parallel plates is expressed by a product of a distance d (m) between parallel plate electrodes and a gas pressure p (Torr) according to Paschen's law. A relationship between the discharge start voltage and the pd product depends on a kind of a gas, and the discharge start voltage attains the lowest value when the pd product is in a range from 10⁻² to 10⁻¹. Spark discharge occurs when electrons accelerated by an electric field collide against gas molecules to ionize the gas. Therefore, the collision is suppressed when gas molecules decrease. Conversely, when the gas molecules increase, the electrons collide against the gas molecules before the electrons are not accelerated sufficiently. Thereby, the discharge start voltage has a lowest value with respect to a gas pressure.

It is now assumed that steps are operated with different gas pressures and different kinds of gases in the same plasma reaction chamber having inter-electrode distance d of a substantially constant value. In this case, when inter-electrode distance d is set to minimize the discharge start voltage under one kind of processing conditions, the discharge start voltage unavoidably increases under the other kind of processing conditions so that a higher voltage must be applied for generating the plasma. When the magnitude of the applied voltage is insufficient, the plasma does not occur, or the generated plasma cannot keep a uniform state.

Even when the plasma reaction chamber has a structure that allows adjustment of inter-electrode distance d, a variable range therefore may be restricted, in which case it is not necessarily possible to minimize the discharge start voltages in the respective plasma processing steps or to attain substantially the same discharge start voltages in the respective plasma processing steps. Such a case may occur that the discharge start voltages in the respective plasma processing steps are different from each other.

Thus, when the plasma processing steps are performed under different processing conditions in the same plasma reaction chamber, respectively, the gas or its pressure in each step is different from that of the other step so that the discharge start voltage increases in one of the steps. In this step, it is necessary to apply a high voltage for generating and keeping uniform plasma.

When a high voltage is applied between the electrodes, uniform plasma can be generated and kept between the electrodes. However, this results in application of an excessive quantity of power between the electrodes, and thus increases a quantity of the power used for gas decomposition. Therefore, a plasma processing speed rises, resulting in a problem that a throughput cannot be controlled without difficulty.

Particularly, the following problem arises when a multilayer silicon-base thin film photoelectric conversion element including a crystalline silicon-base photoelectric conversion layer and an amorphous silicon-base photoelectric conversion layer is formed in the same plasma reaction chamber (deposition chamber) by the CVD method.

Generally, ranges of formation conditions and apparatus configurations for forming the crystalline silicon-base thin film layer of a good quality are limited as compared with those for the amorphous silicon-base thin film layer. Therefore, when both kinds of thin film layers are to be formed in the same plasma CVD chamber, the apparatus configurations are designed to match the conditions of the crystalline silicon-base thin film layer.

As described above, for forming the crystalline silicon-base semiconductor layer, it is necessary to apply a larger power than that for forming the amorphous silicon-base semiconductor layer. When crystalline silicon-base semiconductor layer is used as a photoelectric conversion layer, the film thickness must be increased because its absorption coefficient is small. Accordingly, a higher deposition speed is required for forming the crystalline silicon-base semiconductor layer. For these reasons, the CVD apparatus is usually designed to have configurations that can supply a larger power to the plasma under the conditions for forming the crystalline silicon-base semiconductor layer.

When the apparatus thus designed is used for forming the amorphous silicon-base semiconductor layer in the same deposition chamber, the following problem arises because the formation conditions thereof are different from those of the crystalline silicon-base semiconductor layer. When the amorphous silicon-base semiconductor layer is to be formed, a hydrogen concentration of a material gas is small (a dilution ratio of the material gas is small). Therefore, if the supplied power is substantially equal in magnitude to that for forming the crystalline silicon-base semiconductor layer, the deposition speed increases, and the control thereof becomes difficult. Further, in the process of forming an i-type amorphous silicon-base semiconductor layer, it is preferable to lower the deposition speed for improving the film quality, as is generally known. It may be envisaged to reduce the applied power for lowering the deposition speed. However, when the applied power is reduced for attaining the desired deposition speed, a voltage applied between electrodes, i.e., an anode and a cathode decreases. In the apparatus configurations matching the formation conditions of the crystalline silicon-base semiconductor layer, it is therefore difficult to generate uniform plasma between the electrodes.

The invention has been made in view of the above matters, and an object of the invention is to provide a plasma processing apparatus that can perform more various plasma processing even in a step of which plasma processing conditions are limited by apparatus configurations, in the case where at least two plasma processing steps are performed in a common plasma reaction chamber.

Another object of the invention is to provide a plasma processing apparatus and method that allows easy control of throughput in the case where at least two plasma processing steps using different plasma generation voltage (discharge start voltages), respectively, are performed in a common plasma reaction chamber, and particularly allows easy control of the throughput by generating and maintaining uniform plasma between electrodes in both the two steps and by reducing a quantity of electric power applied between the electrodes to lower a plasma processing speed, and is also to provide a photoelectric conversion element manufactured by this method.

Further another object of the invention relates to a manufacturing method and apparatus of a silicon-base thin film photoelectric conversion element, and particularly to a method and apparatus that form a semiconductor layer of the silicon-base thin film photoelectric conversion element including an i-type amorphous silicon-base photoelectric conversion layer and an i-type crystalline silicon-base photoelectric conversion layer in a common plasma reaction chamber by a plasma CVD method, and the object is to allow reduction of a deposition speed of the i-type amorphous silicon-base photoelectric conversion layer and to allow generation of uniform plasma between electrodes, i.e., anode and cathode.

### MEANS FOR SOLVING THE PROBLEMS

In summary, the invention provides a plasma processing apparatus including a plasma reaction chamber; a first cathode-anode pair arranged inside the plasma reaction chamber, and including a first cathode; and a first power supply unit switching a first output power between a CW AC power and a pulse-modulated AC power, and supplying the first output power to the first cathode.

According to the plasma processing apparatus of the invention, when at least two plasma processing steps are performed in the same plasma reaction chamber, the CW AC power and the pulse-modulated AC power can be appropriately selected as the power for plasma processing. Thereby, the plasma processing can be performed in more various manners even in the step of which plasma processing conditions are limited by apparatus configurations.

Preferably, the plasma processing apparatus further includes a gas pressure varying unit capable of varying a gas pressure in the plasma reaction chamber.

Preferably, the first power supply unit includes a power output unit supplying the CW AC power, and a modulation unit. The modulation unit performs pulse modulation on the CW AC power supplied from the power output unit when the pulse-modulated AC power is to be supplied as the first output power. The modulation unit stops the pulse modulation to pass the CW AC power when the CW AC power is to be supplied as the first output power.

Preferably, the first power supply unit includes a CW power output unit supplying the CW AC power, a pulse power output unit supplying the pulse-modulated AC power, and a switching unit switching the first output voltage between the output of the CW power output unit and the output of the pulse power output unit.

Preferably, the plasma processing apparatus further includes a second cathode-anode pair arranged in the plasma reaction chamber and including a second cathode.

Preferably, the plasma processing apparatus further includes an impedance matching circuit. The impedance matching circuit performs impedance matching between the first cathode-anode pair and the first power supply unit, and performing impedance matching between the second cathode-anode pair and the first power supply unit.

Preferably, the plasma processing apparatus further includes a first impedance matching circuit performing impedance matching between the first cathode-anode pair and the first power supply unit; a second power supply unit switching a second output power between the CW AC power and the pulse-modulated AC power, and supplying the second output power to the second cathode; and a second impedance matching circuit performing impedance matching between the second cathode-anode pair and the second power supply unit.

Preferably, the plasma processing apparatus is an apparatus of manufacturing a silicon-base thin film photoelectric conversion element including at least an i-type amorphous silicon-base photoelectric conversion layer and an i-type crystalline silicon-base photoelectric conversion layer. The modulation unit outputs the pulse-modulated AC power when the i-type amorphous silicon-base photoelectric conversion layer is to be formed. The modulation unit outputs the CW AC power when the i-type crystalline silicon-base photoelectric conversion layer is to be formed.

According to another aspect of the invention, a plasma processing method performing at least two kinds of plasma processing in a common plasma reaction chamber, includes the steps of performing first plasma processing by using a CW AC power as a power for the plasma processing; performing second plasma processing by using a pulse-modulated AC power as a power for the plasma processing; and switching the power for the plasma processing between the CW AC power and the pulse-modulated AC power.

According to the plasma processing method of the invention, when at least two plasma processing steps are performed in the same plasma reaction chamber, the CW AC power and the pulse-modulated AC power can be appropriately selected as the power for plasma processing. Thereby, the plasma processing can be performed in more various manners even in the step of which plasma processing conditions are limited by apparatus configurations.

Preferably, a discharge start voltage in the second plasma processing is set higher than a discharge start voltage in the first plasma processing.

The plasma processing step in which the discharge start voltage is low uses the CW AC power as the power for the plasma processing, and the plasma processing step in which the discharge start voltage is high uses the pulse-modulated AC power as the power for the plasma processing. Therefore, even in the plasma processing step using the high discharge start voltage, the uniform plasma can be generated and maintained between the electrodes. Further, the plasma processing speed can be lowered by reducing a quantity of the power supplied between the electrodes. Thereby, throughput can be controlled easily.

Preferably, a cathode-anode pair is arranged in the plasma reaction chamber. An inter-electrode distance in the cathode-anode pair is uniform in the first and second plasma processing.

Preferably, a gas pressure in the plasma reaction chamber in the first plasma processing is different from that in the second plasma processing.

Preferably, a gas supplied into the plasma reaction chamber and decomposed in the first plasma processing is ionized more easily than a gas supplied into the plasma reaction chamber and decomposed in the second plasma processing when the voltage is constant in magnitude.

Preferably, the first plasma processing is film deposition processing performed by a plasma CVD method, and the second plasma processing is plasma etching processing.

Preferably, the plasma etching processing etches a film adhered to an inner wall of the plasma reaction chamber due to the deposition processing.

Preferably, the plasma processing method is a method forming an photoelectric conversion element including a plurality of semiconductor layers. The deposition processing is processing forming at least one of the plurality of semiconductor layers.

Preferably, the first plasma processing and the second plasma processing are steps forming a semiconductor film by a plasma CVD method.

Preferably, the plasma processing method is a method forming a photoelectric conversion element including a crystalline silicon-base photoelectric conversion layer and an amorphous silicon-base photoelectric conversion layer. The first plasma processing is processing forming the crystalline silicon-base photoelectric conversion layer by a plasma CVD method. The second plasma processing is processing forming the amorphous silicon-base photoelectric conversion layer by the plasma CVD method.

Preferably, the plasma processing method further includes a step of etching a film adhered to an inner wall of the plasma reaction chamber by using a pulse-modulated AC power, after the crystalline silicon-base photoelectric conversion layer and the amorphous silicon-base photoelectric conversion layer are formed.

Preferably, the crystalline silicon-base photoelectric conversion layer is an i-type crystalline silicon-base photoelectric conversion layer. The amorphous silicon-base photoelectric conversion layer is an i-type amorphous silicon-base photoelectric conversion layer.

By generating the plasma using the CW AC power in the step of forming the i-type crystalline silicon-base photoelectric conversion layer, a large power can be supplied so that the i-type crystalline silicon-base photoelectric conversion layer of a good quality can be formed at a faster deposition speed. Also, in the step of forming the i-type amorphous silicon-base photoelectric conversion layer in the same plasma reaction chamber as the step of forming the i-type crystalline silicon-base photoelectric conversion layer, the pulse-modulated AC power is used. The instantaneously applied voltage can be increased to generate the uniform plasma between the electrodes. Further, the time-averaged value of the power quantity can be reduced by supplying the power in a pulse-like fashion so that the deposition speed can be lowered. Thereby, the i-type amorphous silicon-base photoelectric conversion layer can be uniformly formed in an inplane-direction at a desired deposition speed even in the step of forming the i-type amorphous silicon-base photoelectric conversion layer.

Preferably, a cathode-anode pair is arranged in the plasma reaction chamber. An inter-electrode distance in the cathode-anode pair is uniform in the first and second plasma processing.

Preferably, the photoelectric conversion element further includes a p-type semiconductor layer formed of an amorphous silicon-base semiconductor arranged on a light incoming side of the i-type amorphous silicon-base photoelectric conversion layer, and a buffer layer formed of an amorphous silicon-base semiconductor arranged between the i-type amorphous silicon-base photoelectric conversion layer and the p-type semiconductor layer. The plasma processing method further includes a step of forming the p-type semiconductor layer; and a step of forming the buffer layer by using a pulse-modulated AC power.

According to still another aspect of the invention, a photoelectric conversion element manufactured by a plasma processing method performing at least two kinds of plasma processing in a plasma reaction chamber, includes a crystalline silicon-base photoelectric conversion element formed by plasma CVD processing using a CW AC power, and an amorphous silicon-base photoelectric conversion layer formed by plasma CVD processing using a pulse-modulated AC power.

### EFFECTS OF THE INVENTION

According to the invention, when at least two plasma processing steps are performed in the same plasma reaction chamber, one of the steps can perform the plasma processing using the CW AC power, and the other step can perform the plasma processing using the pulse-modulated AC power. Thereby, the plasma processing can be performed in various manners even in the step of which plasma processing conditions are limited due to the apparatus configuration.

Also, according to the invention, when at least two plasma processing steps of which discharge start voltages are different from each other are performed in the same plasma reaction chamber, respectively, the first plasma processing step performed with the low discharge start voltage uses the CW AC power as the plasma processing power, i.e., the power for the plasma processing, and the second plasma processing step performed with the high discharge start voltage uses the pulse-modulated AC power as the plasma processing power. Thereby, even in the second plasma processing step performed with the high discharge start voltage, a high voltage can be applied between the cathode and anode, and the time-averaged value of the applied power can be reduced. According to the invention, therefore, the uniform plasma can be generated and kept between the electrodes, and the plasma processing speed can be reduced so that the throughput can be controlled easily.

Further, the invention can achieve the following effects.

In the case where the i-type amorphous silicon-base photoelectric conversion layer and the i-type crystalline silicon-base photoelectric conversion layer are formed under different deposition conditions by the plasma CVD method in the same plasma reaction chamber, the apparatus configuration is generally designed suitably for the formation of the i-type crystalline silicon-base photoelectric conversion layer. This is because the conditions and apparatus configuration for forming the crystalline silicon-base photoelectric conversion layer of a good quality can be set in ranges narrower than those for the amorphous silicon-base thin film layer.

As is well known, in the step of forming the i-type crystalline silicon-base photoelectric conversion layer, it is preferable to increase the power applied to the plasma in view of improvements and the like in deposition speed and crystallinity, and it is preferable to lower the deposition speed for improving the film quality in the step of forming the i-type amorphous silicon-base photoelectric conversion layer.

In the apparatus, if the deposition speed were lowered for forming the i-type amorphous silicon-base photoelectric conversion layer of a good quality, it would become impossible to generate uniform plasma between the anode and cathode, and the i-type amorphous silicon-base photoelectric conversion layer of a good quality could not be formed uniformly in the direction of the substrate surface.

According to the invention, the CW AC power is used to generate the plasma in the step of forming the i-type crystalline silicon-base photoelectric conversion layer, and thereby a large power can be supplied so that the i-type crystalline silicon-base photoelectric conversion layer of a good quality can be formed at a higher deposition speed. Also, the pulse-modulated AC power is used in the step of forming the i-type amorphous silicon-base photoelectric conversion layer in the same plasma reaction chamber as the step of forming the above i-type crystalline silicon-base photoelectric conversion layer. By increasing the instantaneously applied voltage, the uniform plasma is generated between the electrodes. Also, the time-averaged value of the power quantity is reduced by supplying the power in a pulse-like form. Thereby, the deposition speed can be lowered. Therefore, even in the step of forming the i-type amorphous silicon-base photoelectric conversion layer, the i-type amorphous silicon-base photoelectric conversion layer of a high quality can be formed uniformly in the substrate surface direction at a desired deposition speed.

### BRIEF DESCRIPTION OF THE DRAWINGS

Fig. 1 is a schematic cross section of a plasma processing apparatus according to an embodiment of the invention.
Fig. 2 schematically and equivalently shows a power supply unit of the plasma processing apparatus of Fig. 1.
Fig. 3 schematically and equivalently shows the power supply unit of the plasma processing apparatus of Fig. 1.
Fig. 4 is a schematic cross section of a silicon-base thin film photoelectric conversion element according to third, fourth and fifth embodiments.
Fig. 5 is a schematic cross section of a silicon-base thin film photoelectric conversion element according to a sixth embodiment.
Fig. 6 schematically shows a plasma processing apparatus according to a ninth embodiment.
Fig. 7 schematically shows a plasma processing apparatus according to a tenth embodiment.

### DESCRIPTION OF THE REFERENCE SIGNS

101 1 plasma reaction chamber, 102 cathode, 103 anode, 105 impedance matching circuit, 107 work, 108 power supply unit, 108a power output unit, 108b modulation unit, 108c CW power output unit, 108d pulse power output unit, 108e switching unit, 201 substrate, 206 silicon-base thin film photoelectric conversion element, 211 first p-type semiconductor layer, 212 i-type amorphous silicon-base photoelectric conversion layer, 213 first n-type semiconductor layer, 214 first pin structure multilayer unit, 221 second p-type semiconductor layer, 222 i-type crystalline silicon-base photoelectric conversion layer, 223 second n-type semiconductor layer, 224 second pin structure multilayer unit, 301 buffer layer

### BEST MODES FOR CARRYING OUT THE INVENTION

Embodiments of the invention will now be described with reference to the drawings. In the following description, the same or corresponding portions bear the same reference numbers, and description thereof is not repeated in principle.

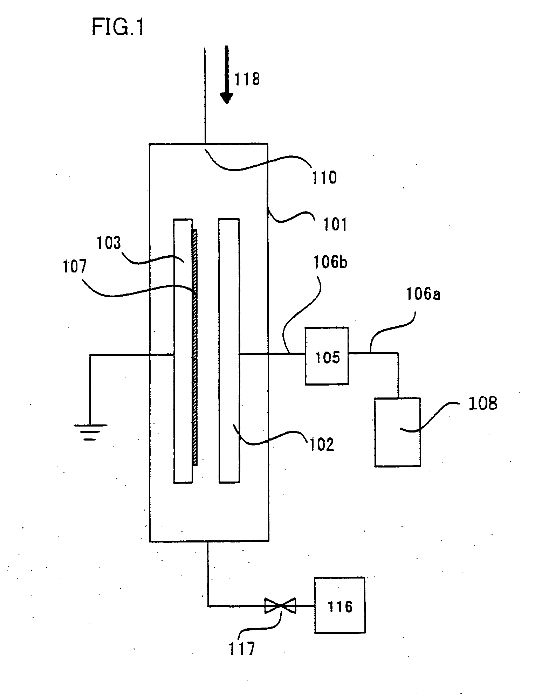

Fig. 1 is a schematic cross section of a plasma processing apparatus according to the embodiment.

The plasma processing apparatus in Fig. 1 is an apparatus for depositing a semiconductor layer by a plasma CVD method. This plasma processing apparatus has a sealable plasma reaction chamber 101 and a pair of cathode 102 and anode 103 that are a parallel plate type of electrodes and are arranged in plasma reaction chamber 101. An inter-electrode distance between cathode 102 and anode 103 is determined according to predetermined processing conditions, and is generally in a range from several millimeters to tens of millimeters.

Cathode 102 and anode 103 are generally fixed. However, at least one of cathode 102 and anode 103 may be movable to allow adjustment of the inter-electrode distance. In this movable structure, the inter-electrode distance can be adjusted according to formation conditions in each step. However, the movable structure is not suitable for a mass-produced apparatus in view of complication of the apparatus and maintenance. Also, a movable range thereof is restricted so that this structure is not practical.

Outside plasma reaction chamber 101, there are arranged a power supply unit 108 supplying an electric power to cathode 102, and an impedance matching circuit 105 that performs impedance matching between power supply unit 108 and the pair of cathode 102 and anode 103.

Power supply unit 108 is connected to an end of a power input line 106a. The other end of power input line 106a is connected to impedance matching circuit 105. An end of a power input line 106b is connected to impedance matching circuit 105. The other end of power input line 106b is connected to cathode 102.

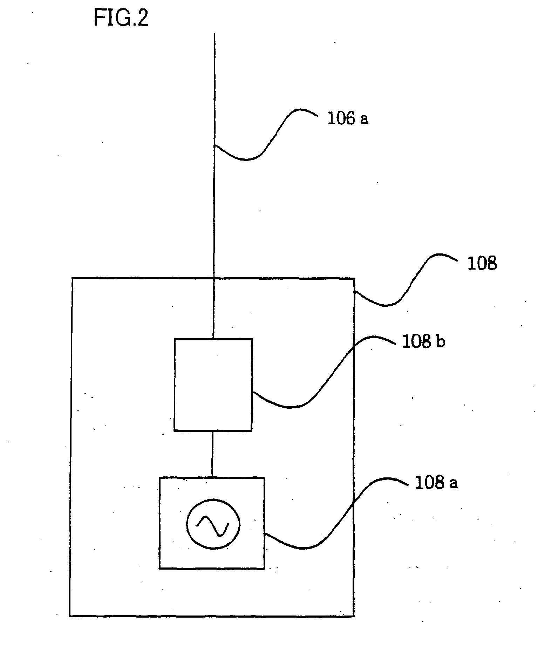

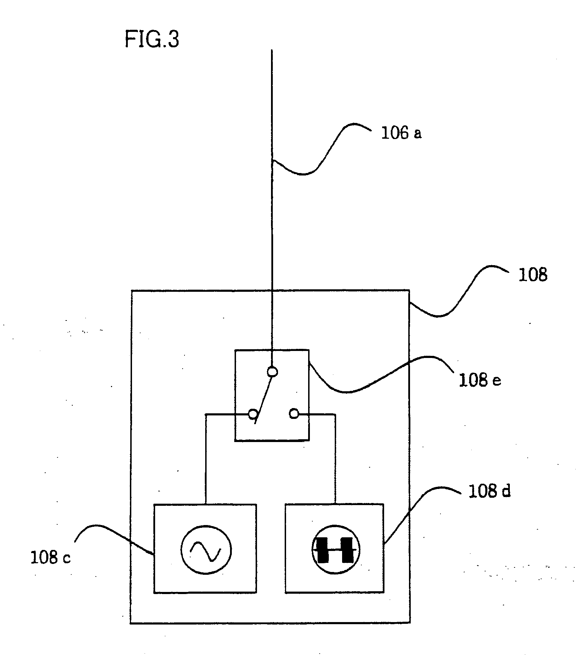

Power supply unit 108 is merely required to supply a CW (continuous wave) AC output and a pulse-modulated (i.e., on/off-controlled) AC output. For example, Figs. 2 and 3 equivalently show configuration examples of power supply unit 108.

In Fig. 2, power supply unit 108 includes a power output unit 108a and a modulation unit 108b. Modulation unit 108b modulates the CW AC power supplied from power output unit 108a, and externally outputs it therefrom. Switching of the output is performed between outputting the CW AC power as it is without modulating it by modulation unit 108b and outputting the AC power subjected to the pulse-modulation by modulation unit 108b. Owing to this configuration, power output unit 108a outputting the AC power can be used commonly to the operation of outputting the CW AC power and the operation of outputting the pulse-modulated AC power. This offers an advantage that power supply unit 108 can have a simple structure.

As shown in Fig. 3, power supply unit 108 may include a CW power output unit 108c, a pulse power output unit 108d and a switching unit 108e selecting the outputs thereof. Switching unit 108e appropriately selects the CW power supplied from CW power output unit 108c and the pulse power supplied from pulse power output unit 108d, and provides the selected AC power externally from power supply unit 108.

The AC power supplied from power supply unit 108 generally has a frequency of 13.56 MHz. However, the frequency of the AC power is not restricted to the above, and a frequency of several kilohertz or in a VHF band and further a frequency in a microwave band may be used. The on time and off time of the pulse modulation can be arbitrarily set, and are set in a range from several microseconds to several milliseconds.

Anode 103 is electrically grounded, and a work 107 is arranged on anode 103.

Work 107 may be arranged on cathode 102, but is generally arranged on anode 103 for suppressing lowering of a film quality due to ion damages in plasma.

Plasma reaction chamber 101 is provided with a gas inlet port 110. Since gas inlet port 110 is supplied with a gas 118 such as a dilution gas, a material gas, a dopant gas and the like.

A vacuum pump 116 and a pressure regulation valve 117 are connected in series to plasma reaction chamber 101, and a substantially constant gas pressure is kept in plasma reaction chamber 101. Pressure regulation valve 117 can change the gas pressure in plasma reaction chamber 101.

### (First Embodiment)

A plasma processing apparatus and method according to this embodiment are configured to deposit semiconductor layers of a thin film amorphous silicon photoelectric conversion element having a pin structure on work 107 by the plasma CVD method in the same plasma reaction chamber 101.

The p-type amorphous silicon layer and the i-type amorphous silicon layer are deposited using a pulse-modulated AC power as a power supply for the plasma processing (a second plasma processing step), and the n-type amorphous silicon layer is deposited using a CW AC power as a power supply for the plasma processing (a first plasma processing step).

The p-type amorphous silicon layer can be deposited under the following deposition conditions. The pressure in plasma reaction chamber 101 during the deposition is desirably in a range from 200 Pa to 3000 Pa, and is 400 Pa in this embodiment. A base temperature of a substrate 201 is desirably 250°C or lower, and is 180°C in this embodiment. A pulse-modulated AC power having a frequency of 13.56 MHz is used as the power supplied to cathode 102 for the plasma processing. A power density per unit area of cathode 102 is desirably in a range from 0.01 W/cm² to 0.3 W/cm², and is 0.1 W/cm² in this embodiment. The on time and off time of the pulse modulation can be set according to a desired deposition speed, and are usually set in a range from several microseconds to several milliseconds. In this embodiment, the on time is 50 microseconds, and the off time is 100 microseconds.

A gas mixture supplied into plasma reaction chamber 101 1 contains a silane gas, hydrogen gas and diborane gas. A flow rate of the hydrogen gas is desirably about several to tens of times larger than that of the silane gas, and is 10 times larger than that of the silane gas in this embodiment.

The p-type amorphous silicon layer desirably has a thickness of 2 nm or more for applying a sufficient internal electric field to the i-type amorphous silicon layer. However, for suppressing a light absorption quantity of the inactive layer, i.e., the p-type amorphous silicon layer and thereby increasing the light reaching the i-type amorphous silicon layer, it is desired to reduce the p-type amorphous silicon layer as far as possible. Accordingly, the thickness of the p-type amorphous silicon layer is usually equal to 50 nm or less. In this embodiment, the thickness of the p-type amorphous silicon layer is 20 nm.

The p-type amorphous silicon layer has the very small thickness of 50 nm or less. The control of this thickness is important for reducing the light absorption quantity. In this embodiment, the deposition speed is lowered by using the pulse-modulated AC power in the plasma processing. Thereby, the thickness of the p-type amorphous silicon layer can be easily controlled.

The i-type amorphous silicon layer can be deposited under the following deposition conditions. The pressure in plasma reaction chamber 101 1 during the deposition is desirably in a range from 200 Pa to 3000 Pa, and is 400 Pa in this embodiment. The base temperature of substrate 201 is desirably equal to or lower than 250°C, and is equal to 180°C in this embodiment. A pulse-modulated AC power having a frequency of 13.56 MHz is used as the power supplied to cathode 102 for the plasma processing. The power density per unit area of cathode 102 is desirably in a range from 0.01 W/cm² to 0.3 W/cm², and is equal to 0.1 W/cm² in this embodiment. The on time and off time of the pulse modulation can be set according to a desired deposition speed, and are usually set in a range from several microseconds to several milliseconds. In this embodiment, the on time is 50 microseconds, and the off time is 100 microseconds.

A gas mixture supplied into plasma reaction chamber 101 1 contains a silane gas and a hydrogen gas. A flow rate of the hydrogen gas is preferably 5 to 20 times larger than that of the silane gas, and the i-type amorphous silicon layer of a good quality can be deposited. This flow rate is 10 times larger than that of the silane gas in this embodiment.

The thickness of the i-type amorphous silicon layer is set in a range from 0.1 µm to 0.5 µm in view of the light absorption quantity and the lowering of the characteristics due to light degradation. In this embodiment, the i-type amorphous silicon layer has the thickness of 0.3 µm.

If the deposition speed of the i-type amorphous silicon layer is excessively high, lowering of the film quality such as increase in defect density in the film occurs, as is generally known. Accordingly, the control of deposition speed is important. For lowering the deposition speed, this embodiment uses the pulse-modulated AC power for the plasma processing.

The n-type amorphous silicon layer can be deposited under the following deposition conditions. The pressure in plasma reaction chamber 101 during the deposition is desirably in a range from 200 Pa to 3000 Pa, and is 400 Pa in this embodiment. The base temperature of substrate 201 is desirably equal to or lower than 250°C, and is equal to 180°C in this embodiment. A CW AC power having a frequency of 13.56 MHz is used as the power supplied to cathode 102 for the plasma processing. The power density per unit area of cathode 102 is desirably in a range from 0.02 W/cm² to 0.5 W/cm², and is equal to 0.3 W/cm² in this embodiment.

A gas mixture supplied into plasma reaction chamber 101 contains a silane gas, hydrogen gas and phosphine gas. A flow rate of the hydrogen gas is preferably 5 to 20 times larger than that of the silane gas, and is 10 times larger than that of the silane gas in this embodiment.

The thickness of the n-type amorphous silicon layer is preferably 2 nm or more for applying a sufficient internal electric field to the i-type amorphous silicon layer. However, for suppressing the light absorption quantity of the inactive layer, i.e., n-type amorphous silicon layer, it is preferable to reduce the thickness of the n-type amorphous silicon layer as far as possible. Accordingly, the thickness of the n-type amorphous silicon layer is usually 50 nm or less. In this embodiment, the thickness of the n-type amorphous silicon layer is 40 nm.

Under the above conditions, the semiconductor layers of the thin film amorphous silicon photoelectric conversion element are deposited.

When at least two plasma processing steps are executed in the same plasma reaction chamber 101, the apparatus configurations may limit the processing conditions because the same apparatus configurations are used in the respective steps. According to this embodiment, the plasma processing can be performed in various manners by executing the plasma processing using the pulse-modulated AC power and the plasma processing using the CW AC power.

### (Second Embodiment)

A plasma processing apparatus and method according to the embodiment execute a plasma CVD step (i.e., a step including a first plasma processing step) of depositing a thin film on work 107 by a plasma CVD method, and a plasma etching step (a second plasma processing step) of etching another work 107 in the same plasma reaction chamber 101.

The plasma CVD step is merely required to have at least one first plasma processing step using a CW AC power, and may further include a plasma CVD step using a pulse-modulated AC power. The plasma CVD step may be a step of depositing a film of a single layer, may also be a step of depositing a layer of multiple layers. In this embodiment, a film of multiple layers is deposited by the plasma CVD step.

Conversely, the plasma etching step performs the plasma etching using a pulse-modulated AC power, and a discharge start voltage thereof is higher than that in the first plasma processing step.

This embodiment will now be described below.

The plasma CVD method is, e.g., a semiconductor layer deposition step that deposits a silicon-base thin film photoelectric conversion element having a pin structure, using an SiH4 gas diluted with an H2 gas as a material gas as well as B2H6 and PH3 as dopant gases. In the first plasma processing step included in this plasma CVD step, pressure regulation valve 117 regulates the pressure in plasma reaction chamber 101 to keep a constant value (e.g., of about 500 Pa), and cathode 102 is supplied with the CW AC power from power supply unit 108. A distance between cathode 102 and anode 103 is in a range from several millimeters to several tens of millimeters. This inter-electrode distance depends on desired deposition conditions. This step deposits the silicon-base thin film on work 107.

In the plasma etching step, a partially masked silicon substrate is set as work 107, and an NF3 gas that is diluted, e.g., with an Ar gas of a flow rate several times larger than that of the NF3 is used as an etching gas. In this step, the pressure in plasma reaction chamber 101 is regulated to attain a constant value, e.g., of about 500 Pa, and cathode 102 is supplied with the pulse-modulated AC power supplied from power supply unit 108. Instead of the NF3 gas, a fluorine-base etching gas such as a CF4 gas diluted with an inert gas such as an Ar gas may be used as the etching gas. This step can perform desired etching on an unmasked portion of the silicon substrate surface.

The plasma CVD step and plasma etching step described above are executed in the same plasma reaction chamber 101. In both steps, the inter-electrode distance between cathode 102 and anode 103 is constant, and the set gas pressure is substantially uniform. In this case, the foregoing pd product is substantially constant. However, ionization of the gas mixture of the NF3 gas and Ar gas used in the plasma etching step is likely to occur as compared with the gas mixture of the SiH4 gas and H2 gas used in the plasma CVD step so that the discharge start voltage in the plasma etching step is higher than that in the plasma CVD step. Therefore, a further higher voltage must be supplied for generating and maintaining the uniform plasma between the electrodes in the plasma etching step. When the CW AC power is used in this step, an excessive quantity of power is supplied for generating and maintaining the plasma, and the plasma occurs in an insulated portion other than the inter-electrode portion between cathode 102 and anode 103 so that this portion may be damaged.

In this embodiment, since the pulse-modulated AC power is supplied to cathode 102 in the plasma etching step, a high voltage can be applied between cathode 102 and anode 103 to generate the uniform plasma without difficulty. Further, the quantity of the supplied power can be kept small by adjusting the duty ratio of the pulse. Thereby, the etching speed can be reduced, and therefore can be controlled easily. Also, the damages of the apparatus can be prevented.

The embodiment of the invention is not restricted to the above, and it is merely required to include the plasma etching step and the plasma CVD step that has the first plasma processing step using the lower discharge start voltage than the plasma etching step. Usually, the gas used in the plasma CVD step is different from the gas used in the plasma etching step, and a difference occurs in discharge start voltage between these steps so that the plasma processing method of the invention can be employed. Also, even when the conditions of the pressure set in plasma reaction chamber 101 in each step are different from those in the other step, a large difference may occur in discharge start voltage so that the plasma processing apparatus of the invention can be effectively employed.

### (Third Embodiment)

In a plasma processing apparatus and method according to this embodiment, at least two plasma CVD steps of which discharge start voltages are different from each other are executed in the same plasma reaction chamber 101. As an example thereof, description will now be given on a plasma processing apparatus and method that deposit a semiconductor layer of a silicon-base thin film photoelectric conversion element.

It is noted that the effect of the invention that is achieved by the following embodiment can likewise be achieved by such a semiconductor layer forming step of a silicon-base thin film photoelectric conversion element that includes a step of forming an i-type amorphous silicon-base photoelectric conversion layer by a pulse-modulated AC power and a step of forming an i-type crystalline silicon-base photoelectric conversion layer by a CW AC power.

The plasma processing apparatus implementing the embodiment is similar to that shown in Fig. 1.

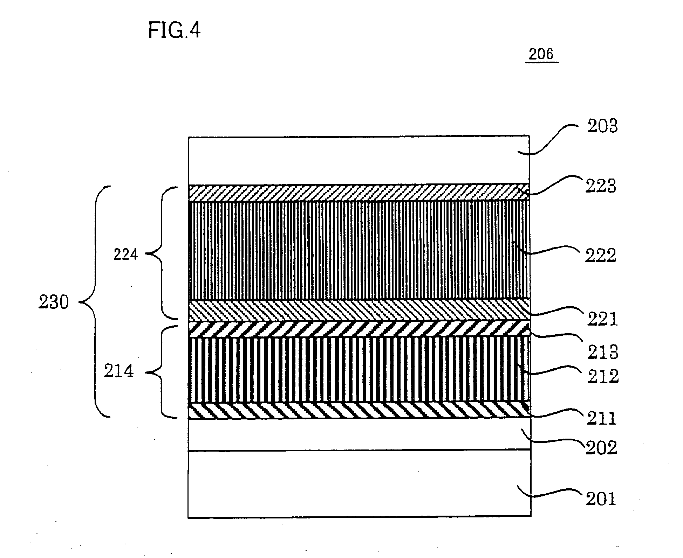

Fig. 4 is a schematic cross section of a silicon-base thin film photoelectric conversion element manufactured by the plasma processing apparatus according to the embodiment. Referring to Fig. 4, a first electrode 202 is deposited on a substrate 201. A first p-type semiconductor layer 211, i-type amorphous silicon-base photoelectric conversion layer 212 and first n-type semiconductor layer 213 are successively layered on first electrode 202. Thereby, a first pin structure multilayer body 214 is deposited on first electrode 202. Subsequently, a second p-type semiconductor layer 221, i-type crystalline silicon-base photoelectric conversion layer 222 and second n-type semiconductor layer 223 are successively layered so that a second pin structure multilayer body 224 is deposited on first pin multilayer body 214. First and second pin structure multilayer bodies 214 and 224 form a double pin structure multilayer body 230. A second electrode 203 is deposited on double pin structure multilayer body 230 so that a silicon-base thin film photoelectric conversion element 206 is completed. In this invention, it is assumed that the semiconductor layer contains all the layers in double pin structure multilayer body 230.

Referring to Figs. 1 and 4, transparent substrate 201 on which a transparent conductive film (first electrode 202) is deposited is placed as work 107 on anode 103. Transparent substrate 201 may be placed on cathode 102, but is generally placed on anode 103 for suppressing lowering of the film quality due to ion damages in the plasma.

A dilution gas, material gas and dopant gas are supplied from gas inlet port 110 The dilution gas may be a gas containing a hydrogen gas, and the material gas may be a silane-base gas, methane gas, germane gas or the like. The p-type impurity dopant gas may be a diborane gas or the like, and the n-type impurity dopant gas may be a phosphine gas or the like.

A glass substrate or a resin substrate, e.g., of polyimide having translucency and heat resistance in the plasma CVD deposition process is generally used as substrate 201. In this embodiment, the glass substrate is used as substrate 201.

First electrode 202 is formed of a transparent conductive film, e.g., of SnO₂, ITO or ZnO. These materials are generally deposited by the CVD, sputtering, vapor deposition or the like. In this embodiment, first electrode 202 is made of SnO₂.

Double pin structure multilayer body 230 is deposited by the plasma CVD method in the same plasma reaction chamber 101. In this embodiment, the p-, i- and n-type semiconductor layers are doubly layered in this order on substrate 201 to form the double pin structure.

In this embodiment, first p-type semiconductor layer 211 is a p-type amorphous silicon carbide semiconductor layer doped with boron, i-type amorphous silicon-base photoelectric conversion layer 212 is an i-type amorphous silicon semiconductor layer, and first n-type semiconductor layer 213 is an n-type crystalline silicon semiconductor layer doped with phosphorus. The silicon-base semiconductor layer is generally made of silicon, silicon carbide, silicon germanium or the like. Boron, aluminum or the like is generally used as the p-type dopant of the conductive semiconductor layers, and phosphorus or the like is generally used as the n-type dopant of the same.

Second electrode 203 is made of metal such as silver or aluminum, or is formed of a transparent conductive film of SnO₂ ITO or ZnO, or a multilayer structure thereof. These are generally deposited by the method such as CVD, sputtering or vapor deposition. In this embodiment, ZnO and silver are layered in this order as second electrode 203.

The deposition method of double pin structure multilayer body 230 will be described below.

Double pin structure multilayer body 230 is deposited by the plasma CVD method in the same plasma reaction chamber 101.

The p-type amorphous silicon carbide semiconductor layer that is first p-type semiconductor layer 211 can be deposited under the following deposition conditions. The pressure in plasma reaction chamber 101 during the deposition is desirably in a range from 200 Pa to 3000 Pa, and is 400 Pa in this embodiment. Further, the base temperature of substrate 201 is desirably 250°C or lower, and is 180°C in this embodiment. A pulse-modulated AC power having a frequency of 13.56 MHz is used as the power supplied to cathode 102 for the plasma processing. The power density per unit area of cathode 102 is desirably in a range from 0.01 W/cm² to 0.3 W/cm², and is 0.1 W/cm² in this embodiment. The on time and off time of the pulse modulation can be set according to the desired deposition speed, and are usually set in a range from several microseconds to several milliseconds. In this embodiment, the on time is 50 µs, and the off time is 100 µs.

The gas mixture supplied into plasma reaction chamber 101 1 contains a silane gas, hydrogen gas, methane gas and diborane gas. The material gas supplied into plasma reaction chamber 101 preferably contains a silane-base gas and a dilution gas containing a hydrogen gas, and more preferably contains methane or trimethyldiborane. The flow rate of the hydrogen gas is preferably several to tens of times larger than that of the silane gas, and is 10 times larger than that of the silane gas in this embodiment.

First p-type semiconductor layer 211 desirably has a thickness of 2 nm or more for applying a sufficient internal electric field to i-type amorphous silicon-base photoelectric conversion layer 212. However, it is desired to reduce the thickness of first p-type semiconductor layer 211 as far as possible for suppressing the light absorption quantity of the inactive layer, i.e., first p-type semiconductor layer 211 and thereby increasing the light reaching i-type amorphous silicon-base photoelectric conversion layer 212. Therefore, the p-type amorphous silicon layer usually has the thickness of 50 nm or less. In this embodiment, first p-type semiconductor layer 211 has the thickness of 20 nm.

The i-type amorphous silicon semiconductor layer that is i-type amorphous silicon-base photoelectric conversion layer 212 can be deposited under the following deposition conditions. It is desired that the pressure in plasma reaction chamber 101 during the deposition is desirably in a range from 200 Pa to 3000 Pa, and is 400 Pa in this embodiment. The base temperature of substrate 201 is desirably equal to or lower than 250°C, and is 180°C in this embodiment. A CW AC power having a frequency of 13.56 MHz is used as the power supplied to cathode 102 for the plasma processing. The power density per unit area of cathode 102 is desirably in a range from 0.01 W/cm² to 0.3 W/cm², and is 0.1 W/cm² in this embodiment.

A gas mixture supplied into plasma reaction chamber 101 1 contains a silane gas and hydrogen gas. A flow rate of the hydrogen gas is preferably 5 to 20 times larger than that of the silane gas, and the i-type amorphous photoelectric conversion layer of a good quality can be deposited. This flow rate is 10 times larger than that of the silane gas in this embodiment.

The thickness of i-type amorphous silicon-base photoelectric conversion layer 212 is set in a range from 0.1 µm to 0.5 µm in view of the light absorption quantity and the lowering of the characteristics due to light degradation. In this embodiment, i-type amorphous silicon-base photoelectric conversion layer 212 has the thickness of 0.3 µm.

If the deposition speed of i-type amorphous silicon-base photoelectric conversion layer 212 is excessively high, lowering of the film quality such as increase in defect density of the film occurs, as is generally known. Accordingly, the control of deposition speed is important. In this embodiment, when it is necessary to improve the film quality in view of setting of the thickness, a pulse-modulated AC power may be used for the plasma processing for the purpose of lowering the deposition speed.

The n-type crystalline silicon semiconductor layer that is first n-type semiconductor layer 213 can be deposited under the following deposition conditions. The pressure in plasma reaction chamber 101 during the deposition is desirably in a range from 240 Pa to 3600 Pa, and is 2000 Pa in this embodiment. The base temperature of substrate 201 is desirably equal to or lower than 250°C, and is equal to 180°C in this embodiment. A CW AC power having a frequency of 13.56 MHz is used as the power supplied to cathode 102 for the plasma processing. The power density per unit area of cathode 102 is desirably in a range from 0.02 W/cm² to 0.5 W/cm², and is equal to 0.3 W/cm² in this embodiment.

A gas mixture supplied into plasma reaction chamber 101 contains a silane gas, hydrogen gas and phosphine gas. A flow rate of the hydrogen gas is desirably and roughly thirty to hundreds of times larger than that of the silane gas, and is 100 times larger than that of the silane gas in this embodiment.

The thickness of first n-type semiconductor layer 213 is preferably 2 nm or more for applying a sufficient internal electric field to i-type amorphous silicon-base photoelectric conversion layer 212. However, for suppressing the light absorption quantity of the inactive layer, i.e., first n-type semiconductor layer 213, it is preferable to reduce the thickness of first n-type semiconductor layer 213 as far as possible. Accordingly, the thickness of first n-type semiconductor layer 213 is usually 50 nm or less. In this embodiment, the thickness of first n-type semiconductor layer 213 is usually 40 nm.

Under the above conditions, first pin structure multilayer body 214 is deposited.

Then, the deposition method of second pin structure multilayer body 224 will be described below.

The p-type crystalline silicon semiconductor layer that is second p-type semiconductor layer 221 can be deposited under the following deposition conditions. The pressure in plasma reaction chamber 101 1 during the deposition is desirably in a range from 240 Pa to 3600 Pa, and is 2000 Pa in this embodiment. Further, the base temperature of substrate 201 is desirably 250°C or lower, and is 180°C in this embodiment. A CW AC power having a frequency of 13.56 MHz is used as the power supplied to cathode 102 for the plasma processing. The power density per unit area of cathode 102 is desirably in a range from 0.02 W/cm² to 0.5 W/cm², and is 0.3 W/cm² in this embodiment.

The gas mixture supplied into plasma reaction chamber 101 1 contains a silane gas, hydrogen gas and diborane gas. The flow rate of the hydrogen gas is preferably and roughly thirty to hundreds of times larger than that of the silane gas, and is 100 times larger than that of the silane gas in this embodiment.

Second p-type semiconductor layer 221 preferably has a thickness of 2 nm or more for applying a sufficient internal electric field to i-type crystalline silicon-base photoelectric conversion layer 222. However, it is desired to reduce the thickness of second p-type semiconductor layer 221 as far as possible for suppressing the light absorption quantity of the inactive layer, i.e., second p-type semiconductor layer 221 and thereby increasing the light reaching i-type crystalline silicon-base photoelectric conversion layer 222. Therefore, second p-type semiconductor layer 221 usually has the thickness of 50 nm or less. In this embodiment, second p-type semiconductor layer 221 has the thickness of 40 nm.

Second p-type semiconductor layer 221 may be formed of an alloy material, e.g., of amorphous and crystalline silicon carbide, amorphous silicon germanium or the like. Second p-type semiconductor layer 221 may be formed a plurality of different thin films layered together.

The i-type crystalline silicon-base photoelectric conversion layer 222 can be deposited under the following deposition conditions. It is desired that the pressure in plasma reaction chamber 101 during the deposition is desirably in a range from 240 Pa to 3600 Pa, and is 2000 Pa in this embodiment. The base temperature of substrate 201 is desirably equal to or lower than 250°C, and is 180°C in this embodiment. A CW AC power having a frequency of 13.56 MHz is used as the power supplied to cathode 102 for the plasma processing. The power density per unit area of cathode 102 is desirably in a range from 0.02 W/cm² to 0.5 W/cm², and is 0.3 W/cm² in this embodiment.

A gas mixture supplied into plasma reaction chamber 101 1 contains a silane gas and hydrogen gas. A flow rate of the hydrogen gas is preferably and roughly thirty to one hundred times larger than that of the silane gas, and this flow rate is 100 times larger than that of the silane gas in this embodiment.

The thickness of i-type crystalline silicon-base photoelectric conversion layer 222 is preferably 0.5 µm or more, and more preferably 1 µm or more for operating as the photoelectric conversion layer ensuring a sufficient light absorption quantity. Also, the thickness of i-type crystalline silicon-base photoelectric conversion layer 222 is preferably 20 µm or less, and more preferably 15 µm or less because the productivity of the apparatus must be ensure. In this embodiment, i-type crystalline silicon-base photoelectric conversion layer 222 has the thickness of 2 µm.

In this embodiment, i-type crystalline silicon-base photoelectric conversion layer 222 must have a good quality, and must be deposited at a higher deposition speed. Therefore, the configuration of the plasma processing apparatus is set to be most suitable for the deposition conditions of this step. More specifically, the inter-electrode distance between cathode 102 and anode 103 is set to 15 mm, and the same configuration is employed in all the other steps.

The foregoing processing can provide i-type crystalline silicon-base photoelectric conversion layer 222 having a sufficient crystallization ratio and particularly exhibiting a peak intensity ratio I₅₂₀/I₄₈₀ in a range from 5 to 10 between the peak intensity at 520 nm⁻¹ measured by Raman spectroscopy and the peak intensity at 480 nm⁻¹. Further, as i-type crystalline silicon-base photoelectric conversion layer 222, an i-type crystalline silicon thin film may be used, and also such a crystalline silicon thin film may be used that is of a weak p type (or weak n type), contains a minute quantity of impurities and has a sufficient photoelectric conversion function. Further, i-type crystalline silicon-base photoelectric conversion layer 222 is not restricted to the above crystalline silicon thin film, and may be formed of a thin film of an alloy material, e.g., of silicon carbide or silicon germanium.

The n-type crystalline silicon semiconductor layer that is second n-type semiconductor layer 223 can be deposited under the following deposition conditions. The pressure in plasma reaction chamber 101 during the deposition is desirably in a range from 240 Pa to 3600 Pa, and is 2000 Pa in this embodiment. Further, the base temperature of substrate 201 is desirably 250°C or lower, and is 180°C in this embodiment. A CW AC power having a frequency of 13.56 MHz is used as the power supplied to cathode 102 for the plasma processing. The power density per unit area of cathode 102 is desirably in a range from 0.02 W/cm² to 0.5 W/cm², and is 0.3 W/cm² in this embodiment.

The gas mixture supplied into plasma reaction chamber 101 1 contains a silane gas, hydrogen gas and phosphine gas. The flow rate of the hydrogen gas is preferably and roughly thirty to hundreds of times larger than that of the silane gas, and is 100 times larger than that of the silane gas in this embodiment.

Second n-type semiconductor layer 223 preferably has a thickness of 2 nm or more for applying a sufficient internal electric field to i-type crystalline silicon-base photoelectric conversion layer 222. However, it is preferable to reduce the thickness of second n-type semiconductor layer 223 as far as possible for suppressing the light absorption quantity of the inactive layer, i.e., second n-type semiconductor layer 223. Therefore, second n-type semiconductor layer 223 has the thickness of 50 nm or less. In this embodiment, second n-type semiconductor layer 223 has the thickness of 40 nm.

Second n-type semiconductor layer 223 may be made of an alloy material, e.g., of crystalline silicon carbide or silicon germanium.

According to the above conditions, first and second pin structure multilayer structures 214 and 224 are continuously deposited in the same plasma reaction chamber 101.

Thereafter, second electrode 203 is deposited by depositing the conductive film of ZnO or the like and a metal film of aluminum, silver or the like by the sputtering method or vapor deposition method. Through the steps described above, silicon-base thin film photoelectric conversion element 206 can be manufactured.

In this embodiment, the deposition step (second plasma processing step) for first p-type semiconductor layer 211, i.e., p-type amorphous silicon carbide semiconductor layer uses the pulse-modulated AC power as the power supply for the plasma processing, and the deposition step (first plasma processing step) for i-type crystalline silicon-base photoelectric conversion layer 222 uses the CW AC power.

For keeping the film quality of the deposited film such as the crystallization rate and crystal grain size at a desired level in this step of depositing i-type crystalline silicon-base photoelectric conversion layer 222, it is necessary to set the apparatus configurations such as the distance between cathode 102 and anode 103 to be suitable for this step. For example, in the step of depositing i-type crystalline silicon-base photoelectric conversion layer 222, the distance between cathode 102 and anode 103 is generally set narrow, and the pressure in plasma reaction chamber 101 1 is generally set high, as compared with the step of depositing the amorphous silicon-base semiconductor layer (e.g., amorphous silicon carbide semiconductor layer).

As described above, when first p-type semiconductor layer 211, i.e., the p-type amorphous silicon carbide semiconductor layer is to be deposited in the same plasma reaction chamber 101 1 of the apparatus that is set suitable for the step of depositing i-type crystalline silicon-base photoelectric conversion layer 222, the discharge start voltage is higher than that in the step of depositing i-type crystalline silicon-base photoelectric conversion layer 222 because the deposition conditions (particularly, the set pressure in plasma reaction chamber 101) for layers 222 and 211 are different from each other.

Therefore, for generating and maintaining the uniform plasma in the step of depositing first p-type semiconductor layer 211 (i.e., p-type amorphous silicon carbide semiconductor layer), i.e., the step in which the discharge start voltage is relatively high, it is necessary to supply a larger power. When the supplied power increases, the plasma processing speed increases so that the deposition speed increases. Since the p-type amorphous silicon carbide semiconductor layer, i.e., first p-type semiconductor layer 211 has the very small thickness of 50 nm or less, the deposition speed must be lowered for controlling the thickness.

In this embodiment, therefore, the step of depositing first p-type semiconductor layer 211, i.e., the p-type amorphous silicon carbide semiconductor layer uses the pulse-modulated AC power as the power supply for the plasma processing. This can achieve the lowering of the deposition speed and can also achieve the generating and keeping of the uniform plasma. Thus, the use of the pulse-modulated AC power suppresses the supplied power quantity and therefore can lower the deposition speed. Further, the instantaneously supplied power and voltage can be increased so that the uniform plasma can be generated and kept between the electrodes.

### (Fourth Embodiment)

A plasma processing apparatus according to this embodiment is similar to that shown in Fig. 1. A cross section of a silicon-base thin film photoelectric conversion element according to this embodiment is similar to that of the photoelectric conversion element shown in Fig. 4. Accordingly, the silicon-base thin film photoelectric conversion element and the manufacturing method thereof will be described below with reference to Fig. 4.

A glass substrate or a resin substrate, e.g., of polyimide having translucency and heat resistance in the plasma CVD deposition process is generally used as substrate 201. In this embodiment, the glass substrate is used as substrate 201.

First electrode 202 is formed of a transparent conductive film, e.g., of tin oxide, indium tin oxide or zinc oxide. These materials are generally deposited by the CVD, sputtering, vapor deposition or the like. In this embodiment, first electrode 202 is made of tin oxide.

Double pin structure multilayer body 230 is deposited by the plasma CVD method in the same plasma reaction chamber 101 (deposition chamber). In the silicon-base thin film photoelectric conversion element of this embodiment, the p-, i- and n- type semiconductor layers are layered in this order on substrate 201 to form the pin structure.

In this embodiment, first p-type semiconductor layer 211 is a p-type amorphous silicon carbide semiconductor layer doped with boron, i-type amorphous silicon-base photoelectric conversion layer 212 is an i-type amorphous silicon semiconductor layer, and first n-type semiconductor layer 213 is an n-type crystalline silicon semiconductor layer doped with phosphorus. The silicon-base semiconductor layer is generally made of silicon, silicon carbide, silicon germanium or the like. Boron, aluminum or the like is generally used as the p-type dopant of the conductive semiconductor layers, and phosphorus or the like is generally used as the n-type dopant of the same.

Second electrode 203 is made of metal such as silver or aluminum, or is formed of a transparent conductive film of tin oxide, indium tin oxide or zinc oxide, or a multilayer structure thereof. These are generally deposited by the method such as CVD, sputtering or vapor deposition. In this embodiment, zinc oxide and silver are layered in this order as second electrode 203.

The formation method of double pin structure multilayer body 230 will be described below.

Double pin structure multilayer body 230 is formed by the plasma CVD method in the same plasma reaction chamber 101 1 as described before.

The p-type amorphous silicon carbide semiconductor layer that is first p-type semiconductor layer 211 is formed by supplying the CW AC power to cathode 102 under the following conditions. The deposition pressure is in a range from 200 Pa to 3000 Pa, and the base temperature of substrate 201 is 250°C or lower. The supplied CW AC power has a frequency of 13.56 MHz, and its power density per unit area of the cathode is in a range from 0.01 W/cm² to 0.3 W/cm².

The gas mixture supplied into plasma reaction chamber 101 1 contains a silane gas, hydrogen gas, methane gas and diborane gas. The material gas supplied into plasma reaction chamber 101 1 preferably contains a silane-base gas and a dilution gas containing a hydrogen gas, and more preferably contains methane or trimethylboron. The flow rate of the hydrogen gas is preferably several to tens of times larger than that of the silane gas.

First p-type semiconductor layer 211 desirably has a thickness of 2 nm or more for applying a sufficient internal electric field to i-type amorphous silicon-base photoelectric conversion layer 212. However, it is desired to reduce the thickness of first p-type semiconductor layer 211 as far as possible for suppressing the light absorption quantity of the inactive layer, i.e., first p-type semiconductor layer 211 and thereby increasing the light reaching i-type amorphous silicon-base photoelectric conversion layer 212. Therefore, first p-type semiconductor layer 211 usually has the thickness of 50 nm or less.

The i-type amorphous silicon semiconductor layer that is i-type amorphous silicon-base photoelectric conversion layer 212 is formed by supplying the pulse-modulated AC power to cathode 102 under the following conditions. The deposition pressure is in a range from 200 Pa to 3000 Pa, and the base temperature of substrate 201 is equal to or lower than 250°C. The supplied pulse-modulated AC power has a frequency of 13.56 MHz, and its power density per unit area of the cathode is in a range from 0.01 W/cm² to 0.3 W/cm². The on time and off time of the pulse modulation can be set according to a desired deposition speed, and are usually set in a range from several microseconds to several milliseconds.

A gas mixture supplied into plasma reaction chamber 101 contains a silane gas and hydrogen gas. A flow rate of the hydrogen gas is preferably 5 to 20 times larger than that of the silane gas, and thereby the amorphous i-type photoelectric conversion layer of a good film quality can be formed.

The thickness of i-type amorphous silicon-base photoelectric conversion layer 212 is set in a range from 0.1 µm to 0.5 µm in view of the light absorption quantity and the lowering of the characteristics due to light degradation.

The n-type crystalline silicon semiconductor layer that is first n-type semiconductor layer 213 is formed by supplying the CW AC power to cathode 102 under the following conditions. The deposition pressure is in a range from 240 Pa to 3600 Pa, and the base temperature of substrate 201 is 250°C or lower. The supplied CW AC power has a frequency of 13.56 MHz, and its power density per unit area of the cathode is in a range from 0.02 W/cm² to 0.5 W/cm².

The gas mixture supplied into plasma reaction chamber 101 contains a silane gas, hydrogen gas and phosphine gas. The flow rate of the hydrogen gas is roughly several tens of times larger than that of the silane gas.

First n-type semiconductor layer 213 preferably has a thickness of 2 nm or more for applying a sufficient internal electric field to i-type amorphous silicon-base photoelectric conversion layer 212. However, it is preferable to reduce the thickness of first n-type semiconductor layer 213 as far as possible for suppressing the light absorption quantity of the inactive layer, i.e., first n-type semiconductor layer 213. Therefore, first n-type semiconductor layer 213 usually has the thickness of 50 nm or less.

Under the above conditions, first pin structure multilayer body 214 is formed. Then, the deposition method of second pin structure multilayer body 224 will be described below.

The p-type crystalline silicon semiconductor layer that is second p-type semiconductor layer 221 is formed by supplying the CW AC power to cathode 102 under the following conditions. The deposition pressure is in a range from 240 Pa to 3600 Pa, and the base temperature of substrate 201 is 250°C or lower. The supplied CW AC power has a frequency of 13.56 MHz, and its power density per unit area of the cathode is in a range from 0.02 W/cm² to 0.5 W/cm².

The gas mixture supplied into plasma reaction chamber 101 contains a silane gas, hydrogen gas and diborane gas. The flow rate of the hydrogen gas is roughly tens of times larger than that of the silane gas.

Second p-type semiconductor layer 221 preferably has a thickness of 2 nm or more for applying a sufficient internal electric field to i-type crystalline silicon-base photoelectric conversion layer 222. However, it is desired to reduce the thickness of second p-type semiconductor layer 221 as far as possible for suppressing the light absorption quantity of the inactive layer, i.e., second p-type semiconductor layer 221 and thereby increasing the light reaching i-type crystalline silicon-base photoelectric conversion layer 222. Therefore, second p-type semiconductor layer 221 usually has the thickness of 50 nm or less.

Second p-type semiconductor layer 221 may be formed of a layer of an alloy material, e.g., of amorphous and crystalline silicon carbide, amorphous silicon germanium or the like. Second p-type semiconductor layer 221 may be formed a plurality of different thin films layered together.

i-type crystalline silicon-base photoelectric conversion layer 222 is formed by applying the CW AC power to cathode 102 under the following conditions. The deposition pressure is in a range from 240 Pa to 3600 Pa, and the base temperature of substrate 201 is equal to or lower than 250°C. The supplied CW AC power has a frequency of 13.56 MHz, and its power density per unit area of the cathode is in a range from 0.02 W/cm² to 0.5 W/cm².

A gas mixture supplied into plasma reaction chamber 101 1 contains a silane gas and hydrogen gas. A flow rate of the hydrogen gas is preferably 30 to 100 times larger than that of the silane gas, and more preferably the former is 80 times or less larger than the latter.

The thickness of i-type crystalline silicon-base photoelectric conversion layer 222 is preferably set to 0.5 µm or more, and more preferably 1 µm or more for ensuring a sufficient light absorption quantity as the photoelectric conversion layer. Also, the thickness of i-type crystalline silicon-base photoelectric conversion layer 222 is preferably 20 µm or less, and more preferably 15 µm or less for ensuring the productivity of the apparatus.

The foregoing processing can provide i-type crystalline silicon-base photoelectric conversion layer 222 having a sufficient crystallization ratio and particularly exhibiting a peak intensity ratio I₅₂₀/I₄₈₀ in a range from 5 to 10 between the peak intensity at 520 nm⁻¹ measured by Raman spectroscopy and the peak intensity at 480 mn⁻¹. Further, as i-type crystalline silicon-base photoelectric conversion layer 222, an i-type crystalline silicon thin film may be used, and also such a crystalline silicon thin film may be used that is of a weak p type (or weak n type), contains a minute quantity of impurities and has a sufficient photoelectric conversion function. Further, i-type crystalline silicon-base photoelectric conversion layer 222 is not restricted to the above crystalline silicon thin film, and may be formed of a thin film of an alloy material, e.g., of silicon carbide or silicon germanium.

The n-type crystalline silicon semiconductor layer that is second n-type semiconductor layer 223 can be deposited by supplying the CW AC power to cathode 102 under the following deposition conditions. The deposition pressure is desirably in a range from 240 Pa to 3600 Pa, and the base temperature of substrate 201 is desirably 250°C or lower. The supplied CW AC power has a frequency of 13.56 MHz, and its power density per unit area of cathode 102 in a range from 0.02 W/cm² to 0.5 W/cm².

The gas mixture supplied into plasma reaction chamber 101 contains a silane gas, hydrogen gas and phosphine gas. The flow rate of the hydrogen gas is roughly tens of times larger than that of the silane gas.

Second n-type semiconductor layer 223 preferably has a thickness of 2 nm or more for applying a sufficient internal electric field to i-type crystalline silicon-base photoelectric conversion layer 222. However, it is preferable to reduce the thickness of second n-type semiconductor layer 223 as far as possible for suppressing the light absorption quantity of the inactive layer, i.e., second n-type semiconductor layer 223. Therefore, second n-type semiconductor layer 223 has the thickness of 50 nm or less.

Second n-type semiconductor layer 223 may be made of an alloy material, e.g., of crystalline silicon carbide or silicon germanium.

According to the above conditions, first and second pin structure multilayer structures 214 and 224 are continuously formed in the same plasma reaction chamber 101.

Thereafter, second electrode 203 is deposited by depositing a conductive film of zinc oxide or the like and a metal film of aluminum, silver or the like by the sputtering method or vapor deposition method. Through the steps described above, the silicon-base thin film photoelectric conversion element can be manufactured.

In this embodiment, as described above, the formation step for i-type crystalline silicon-base photoelectric conversion layer 222 uses the CW AC power, and the formation step for i-type amorphous silicon-base photoelectric conversion layer 212 uses the pulse-modulated AC power.

In the formation step of i-type crystalline silicon-base photoelectric conversion layer 222, the silicon-base film is crystallized, and therefore it is necessary to increase the supplied power and the hydrogen concentration of the material gas as compared with the case of forming the amorphous silicon-base thin film so that it is desired to use the CW AC power that allows the supply of a higher power.

Since i-type crystalline silicon-base photoelectric conversion layer 222 has a large thickness from 0.5 µm to 20 µm, it is desired to improve the deposition speed in view of reduction of the film formation time, and also it is desired to use the CW AC power that allows the supply of a high power. For maintaining the film quality such as crystallinity of i-type crystalline silicon-base photoelectric conversion layer 222, the configuration of the manufacturing apparatus of the silicon-base photoelectric conversion element described above is designed to match the formation conditions thereof.

If the formation speed of i-type amorphous silicon-base photoelectric conversion layer 212 is excessively high, lowering of the film quality such as increase in defect density of the film occurs, as is generally known. Accordingly, the control of deposition speed is important. In the step of forming i-type amorphous silicon-base photoelectric conversion layer 212 by the above apparatus, when the supplied power is reduced to attain the desired deposition speed, it becomes difficult to generate uniform plasma between the electrodes, resulting in a problem that the film quality and film thickness of the deposited semiconductor film become irregular in the in-plane direction.

Accordingly, this embodiment uses the pulse-modulated AC power supply in the step of forming i-type amorphous silicon-base photoelectric conversion layer 212. Thereby, it is possible to achieve both the lowering of the deposition speed and the generating of the uniform plasma. Thus, the use of the pulse-modulated AC power suppresses a time-averaged value of the supplied power quantity, and therefore can lower the deposition speed. Further, the instantaneously supplied power and voltage can be increased so that the uniform plasma can be generated.

### (Fifth Embodiment)

A manufacturing method of a silicon-base thin film photoelectric conversion element according to this embodiment will be described below.

The silicon-base photoelectric conversion element of this embodiment has substantially the same structure as that of the fourth embodiment. However, the formation method of first p-type semiconductor layer 211 (see Fig. 4) is different from that of the fourth embodiment. In the fifth embodiment, first p-type semiconductor layer 211 is formed by supplying a pulse-modulated AC power to cathode 102, and the other semiconductor layers are formed by the same formation method as those in the fourth embodiment. The formation method of first p-type semiconductor layer 211 will be described below.

The p-type amorphous silicon carbide semiconductor layer that is first p-type semiconductor layer 211 is formed by supplying the pulse-modulated AC power to cathode 102 under the following conditions. The deposition pressure is in a range from 200 Pa to 3000 Pa, and the base temperature of substrate 201 is equal to or lower than 250°C. The supplied pulse-modulated AC power has a frequency of 13.56 MHz, and its power density per unit area of the cathode is in a range from 0.01 W/cm² to 0.3 W/cm². The on time and off time of the pulse modulation can be set according to a desired deposition speed, and are usually set in a range from several microseconds to several milliseconds.

A gas mixture supplied into plasma reaction chamber 101 contains a silane gas, hydrogen gas, methane gas and diborane gas. The material gas supplied into plasma reaction chamber 101 1 preferably contains a silane-base gas and a dilution gas containing a hydrogen gas, and may contain methane or trimethylboron. The flow rate of the hydrogen gas is preferably several to tens of times larger than that of the silane gas.

First p-type semiconductor layer 211 desirably has a thickness of 2 nm or more for applying a sufficient internal electric field to i-type amorphous silicon-base photoelectric conversion layer 212. However, it is desired to reduce the thickness of first p-type semiconductor layer 211 as far as possible for suppressing the light absorption quantity of the inactive layer, i.e., first p-type semiconductor layer 211 and thereby increasing the light reaching i-type amorphous silicon-base photoelectric conversion layer 212. Therefore, first p-type semiconductor layer 211 usually has the thickness of 50 nm or less. When the it is necessary to adjust or regulate the film thickness of first p-type semiconductor layer 211 for reducing it as far as possible, it is preferable that the control of the film thickness is easy. In this deposition step, power supply unit 108 (see Fig. 1) provides a pulse-modulated AC power to lower the deposition speed, and this is effective in facilitating the film thickness control.

Similarly to the fourth embodiment, the use of the pulse-modulated AC power can increase the instantaneously supplied power and voltage even when the deposition speed is low, and therefore the uniform plasma can be generated.

### (Sixth Embodiment)

A manufacturing method of a silicon-base thin film photoelectric conversion element according to this embodiment will be described below with reference to the drawings.

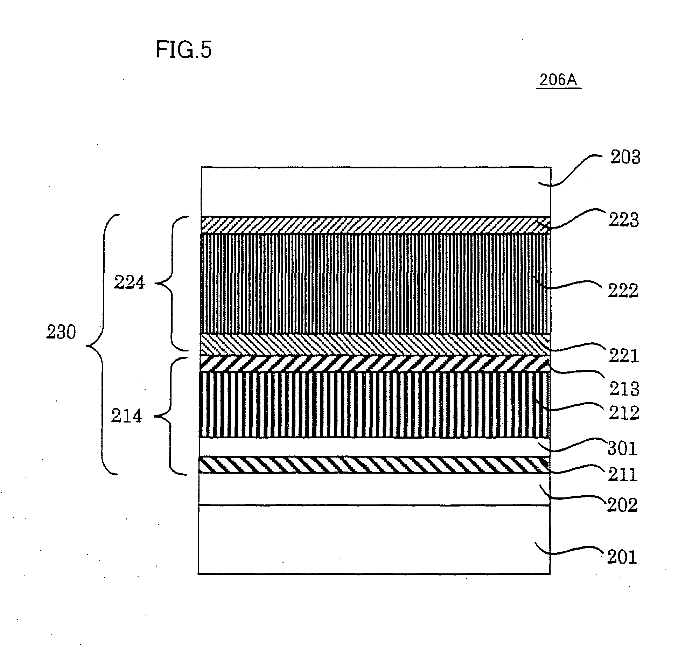

Fig. 5 is a schematic cross section of a silicon-base thin film photoelectric conversion element according to the embodiment. Referring to Figs. 5 and 4, a structure of silicon-base thin film photoelectric conversion element 206A is substantially the same as that of silicon-base thin film photoelectric conversion element 206 except for that a buffer layer 301 made of i-type amorphous silicon-base semiconductor is interposed between first p-type semiconductor layer 211 and i-type amorphous silicon-base photoelectric conversion layer 212.

Buffer layer 301 is formed by supplying the pulse-modulated AC power to cathode 102 under the following conditions. The deposition pressure is in a range from 200 Pa to 3000 Pa, and the base temperature of substrate 201 is equal to or lower than 250°C. The supplied pulse-modulated AC power has a frequency of 13.56 MHz, and the power density thereof per unit area of the cathode is in a range from 0.01 W/cm² to 0.3 W/cm². The on time and off time of the pulse modulation can be set according to a desired deposition speed, and are usually set in a range from several microseconds to several milliseconds.

A gas mixture supplied into plasma reaction chamber 101 1 contains a silane gas, hydrogen gas and methane gas. The material gas supplied into plasma reaction chamber 101 preferably contains a silane-base gas and a dilution gas containing a hydrogen gas, and may contain methane. The flow rate of the hydrogen gas is preferably several to tens of times larger than that of the silane gas.

Buffer layer 301 can reduce diffusion of boron impurities from first p-type semiconductor layer 211 to i-type amorphous silicon-base photoelectric conversion layer 212. Thereby, it is possible to suppress quality lowering of i-type amorphous silicon-base photoelectric conversion layer 212 as well as changes in band profile in i-type amorphous silicon-base photoelectric conversion layer 212. Therefore, when the silicon-base thin film photoelectric conversion element according to the embodiment is used in a solar cell, it is possible to suppress lowering of characteristics of the solar cell.

Buffer layer 301 preferably has a thickness of 2 nm or more in view of reduction of diffusion of boron impurities to i-type amorphous silicon-base photoelectric conversion layer 212, and preferably is 50 nm or less in view of the fact that it is necessary to suppress the light absorption quantity of buffer layer 301.

When first p-type semiconductor layer 211 and buffer layer 301 are formed of amorphous silicon carbide semiconductor films, buffer layer 301 preferably has such a band profile that a band gap decreases continuously or stepwise from the side of first p-type semiconductor layer 211, and this change continues to a boundary between it and i-type amorphous silicon-base photoelectric conversion layer 212. By reducing the band gap of buffer layer 301 continuously or stepwise, discontinuity in band profile at the film interface can be reduced to suppress recoupling of electrons and holes so that the solar cell characteristics can be improved.

The control of this band gap is performed by gradually reducing a flow rate of a methane gas that is one of material gases, and thereby changing a composition of the deposited film. In this step, the reduction of the deposition speed facilitates the adjustment of the flow rate of the methane gas so that buffer layer 301 having a desired band profile can be easily formed.

The manufacturing method of this embodiment can manufacture the silicon-base thin film photoelectric conversion element having better photoelectric conversion efficiency and better optical degradation characteristics than those in the fifth embodiment.

### (Seventh Embodiment)

A plasma processing apparatus and method of this embodiment execute, in the following order, a step of setting substrate 201 on anode 103 in plasma reaction chamber 101, a plasma CVD step of depositing double pin structure multilayer body 230 on substrate 201, a step of taking out substrate 201 and double pin structure multilayer body 230 deposited thereon from plasma reaction chamber 101 and a plasma etching step of etching a residual film on cathode 102 and anode 103 in plasma reaction chamber 101 and on an inner wall of plasma reaction chamber 101.

The plasma CVD step includes a first plasma processing step of depositing the crystalline silicon-base photoelectric conversion layer using a CW AC power. The plasma etching step uses a higher discharge start voltage than the first plasma processing step, and performs the plasma etching using a pulse-modulated AC power. The plasma etching step performs the etching on the silicon-base semiconductor film that adhered in the plasma CVD step to cathode 102 and anode 103 of plasma reaction chamber 101 and to the inner wall of plasma reaction chamber 101.

As is done in this embodiment, the plasma CVD step is merely required to include at least the first plasma processing step using the CW AC power, and it may further include a deposition step using a pulse-modulated AC power. The plasma etching step is merely required to start with the discharge start voltage higher than that in the first plasma processing step and to execute the plasma etching using the pulse-modulated AC power.

This embodiment will be described below in detail.

The plasma processing apparatus of the embodiment has the same configuration as the apparatus shown in Fig. 1. The double pin structure multilayer body formed by the plasma processing apparatus of this embodiment has the same configuration, e.g., as double pin structure multilayer body 230 shown in Fig. 4.

Referring to Fig. 4, double pin structure multilayer body 230 is formed on substrate 201 under the same conditions as the third embodiment.

Referring to Figs. 1 and 4, the plasma CVD step of depositing double pin structure multilayer body 230 is executed multiple times, and then the plasma etching step is performed to etch the residual film on cathode 102 and anode 103 in plasma reaction chamber 101 and on the inner wall of plasma reaction chamber 101. Thereby, the apparatus is cleaned. The conditions of the plasma etching step are the same as those of the plasma etching step in the second embodiment.

Generally, the conditions and apparatus configurations for depositing the good crystalline silicon-base thin film are set in restricted ranges so that the apparatus configurations are designed to match these conditions.

In this embodiment, the plasma CVD step includes the first plasma processing step of depositing the crystalline silicon-base thin film layer, using the CW AC power. In this case, the apparatus configurations such as the inter-electrode distance are set suitable for this step. When this apparatus executes the plasma etching step, i.e., the second plasma processing step, ionization of the gas used therein is less likely to occur so that the discharge start voltage increases. In this embodiment, the plasma etching step is executed by supplying the pulse-modulated AC power to cathode 102 so that the uniform plasma can be generated and kept between the electrodes by applying the high voltage between the electrodes, and the quantity of supplied power can be kept small. Further, this method can reduce the possibility of damaging insulating portions of the apparatus even when the plasma occurs in the portion other that the portion between the electrodes.

### (Eighth Embodiment)

A plasma processing apparatus of this embodiment has substantially the same configuration as that shown in Fig. 1.

The plasma processing method of this embodiment repeats the plasma etching step in the second embodiment, a step of setting substrate 201 on anode 103 in plasma reaction chamber 101, the plasma CVD step in the seventh embodiment (i.e., the plasma CVD step of depositing double pin structure multilayer body 230) and a step of taking out substrate 201 in this order.

The plasma etching step is executed before depositing first pin structure multilayer body 214 to etch outermost and underlying layers of the semiconductor film adhering to anode 102 and cathode 103 as well as the inner wall of plasma reaction chamber 101. For depositing double pin structure multilayer body 230 with good reproducibility, it is preferable that the environment in plasma reaction chamber 101 1 is kept substantially constant at the start of the deposition. For stabilizing the plasma and preventing mixing of impurities, it is desired that a film having a uniform film surface is deposited on cathode 102 and anode 103 as well as the inner wall of plasma reaction chamber 101. It is further desired that the i-type semiconductor layer is exposed on the outermost surface of the residual film.

This step can repeat the deposition of double pin structure multilayer body 230 of a good quality in the same plasma reaction chamber 101.

In this plasma etching step, the surface of the i-type semiconductor layer is exposed by etching the residual film that was deposited on cathode 102 and anode 103 as well as the inner wall of plasma reaction chamber 101 before this plasma etching step. Therefore, the control of the etching thickness is important, and the etching speed must be lowered.

The distance between cathode 102 and anode 103 of the plasma processing apparatus of this embodiment is designed suitably for the plasma CVD step of depositing the i-type crystalline silicon-base photoelectric conversion layer. Therefore, in the plasma etching step using a gas mixture of an inert gas an a fluorine-base etching gas, it is difficult to ionize the etching gas when the applied voltage is the same as that for the plasma generation, and therefore the applied voltage must be higher than that for generating the plasma.

The plasma etching step uses the pulse-modulated AC power for generating the plasma, similarly to the second embodiment. Thereby, even when a high voltage is applied for the purpose of generating and keeping the uniform plasma between the electrodes, the quantity of supplied power can be reduced so that the etching speed can be reduced. Also, the quantity of supplied power can be adjusted by adjusting the duty ratio of the pulse so that the etching thickness can be controlled easily.

### (Ninth Embodiment)

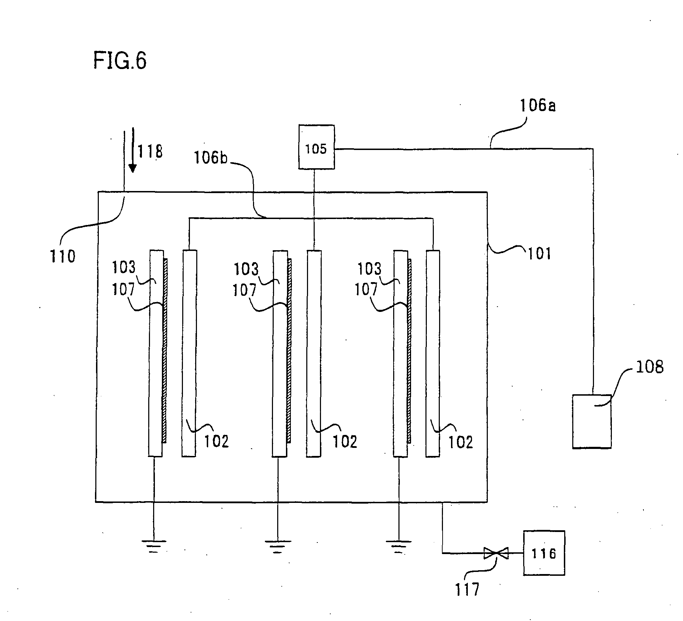

A plasma processing apparatus according to this embodiment will now be described with reference to the drawings. Fig. 6 is a schematic diagram of a plasma processing apparatus according to this embodiment. Referring to Fig. 6, the plasma processing apparatus has a plurality of pairs of anodes 103 and cathodes 102 arranged in plasma reaction chamber 101. The plurality of pairs of anodes 103 and cathodes 102 are connected to power supply unit 108 via one impedance matching circuit 105.

In this structure, it is difficult to generate simultaneously the glow discharge plasma in the plurality of pairs of anodes 103 and cathodes 102. More specifically, when the glow discharge plasma occurs in one or some of the electrode pairs, the impedance between the electrodes of each of such pair(s) becomes small. Thereby, the power supplied between the electrodes of the other pairs decreases, resulting in a problem that the plasma does not occur between these electrodes.

This problem becomes significant in the step where the power and voltage applied to cathode 102 are small, and thus a high voltage must be applied in each electrode pair. The high voltage applied in each electrode pair increases the possibility that the glow discharge plasma simultaneously occurs between the electrodes of all the pairs, and thus can generate the uniform plasma.

However, the high voltage applied in each electrode pair increases the plasma processing speed. Thus, the above matter becomes a problem in the step where the plasma processing speed must be lowered.

In this embodiment, power supply unit 108 can supply the pulse-modulated AC power to cathode 102. Thereby, even when the high voltage is applied in each electrode pair, the uniform plasma can be generated and kept between the electrodes without increasing the plasma processing speed.

When the plasma processing apparatus of this embodiment executes the manufacturing methods of the fourth to sixth embodiments, the pulse-modulated AC power is used in the steps of forming first p-type semiconductor layer 211, i-type amorphous silicon-base photoelectric conversion layer 212 and buffer layer 301. Thereby, the deposition speed can be suppressed. Further, the high voltage can be applied in each electrode pair so that the uniform plasma can be generated. By generating the uniform plasma, it is possible to improve the uniformity of the film quality and film thickness of the silicon-base semiconductor layer in the surface direction of substrate 201.

When the plasma processing apparatus having the configuration of this embodiment executes the plasma etching step using a high discharge start voltage, it is further difficult to generate and keep simultaneously the glow discharge plasma in all the electrode pairs, and a further high application voltage is required. The pulse-modulated AC power can likewise be used effectively in this case.

### (Tenth Embodiment)

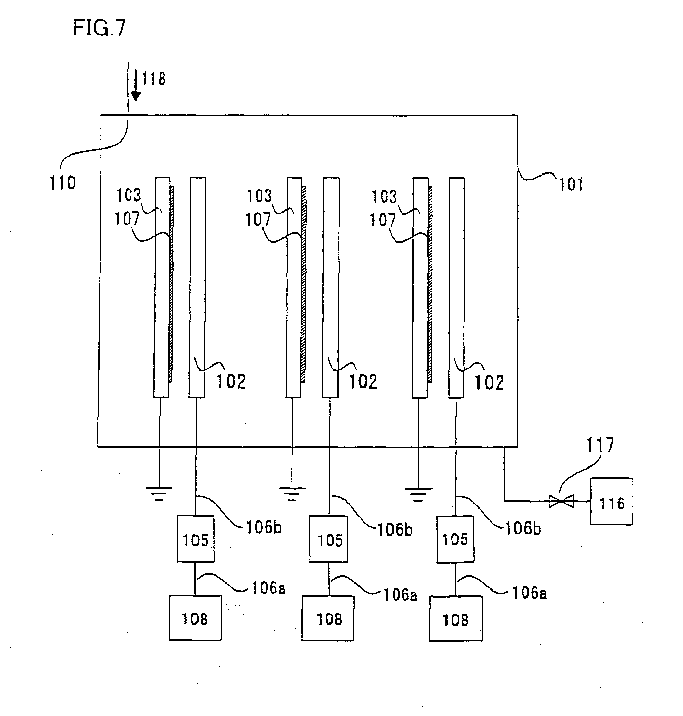

The plasma processing apparatus according to the embodiment will now be described with reference to the drawings. Fig. 7 schematically shows the plasma processing apparatus according to the embodiment. Referring to Fig. 7, the plasma processing apparatus has a plurality of pairs of anodes 103 and cathodes 102 in plasma reaction chamber 101. A plurality of impedance matching circuits 105 are arranged corresponding to the plurality of pairs of anodes 103 and cathodes 102, respectively. Each pair of anode 103 and cathode 102 is connected to power supply unit 108 via corresponding impedance matching circuit 105.

In this structure, the impedance matching of the respective pairs of anodes 103 and cathodes 102 with respect to power supply unit 108 can be performed individually. Thereby, even when anode 103 and cathode 102 have large areas, the uniform plasma can be generated and kept between the electrodes of each pair.

### PRACTICAL EXAMPLE

A practical example of the silicon-base thin film photoelectric conversion element of the invention will be described below.

In this practical example, a multilayer silicon-base thin film photoelectric conversion element was manufactured by continuously forming double pin structure multilayer body 230 shown in Fig. 4 in the same plasma reaction chamber 101 of the plasma processing apparatus shown in Fig. 1. The configuration of the apparatus was designed to match the conditions for forming the crystalline silicon-base semiconductor layer. More specifically, in connection with the conditions for forming the crystalline silicon-base semiconductor layer, the pd product of a pressure p in plasma reaction chamber 101 during the film deposition and a distance d between cathode 102 and anode 103 was adjusted to allow generation of the plasma between cathode 102 and anode 103 without difficulty.

The multilayer silicon-base thin film photoelectric conversion element of this practical example used a glass substrate of 4 mm in thickness as substrate 201. On substrate 201, there were successively layered a tin oxide film of 1 µm in thickness as first electrode 202, an amorphous silicon carbide layer of 10 nm in thickness as first p-type semiconductor layer 211, an amorphous silicon layer of 0.5 µm as i-type amorphous silicon-base photoelectric conversion layer 212, a microcrystalline silicon layer of 30 nm in thickness as first n-type semiconductor layer 213, a microcrystalline silicon layer of 30 nm in thickness as second p-type semiconductor layer 221, a microcrystalline silicon layer of 3 µm in thickness as i-type crystalline silicon-base photoelectric conversion layer 222, a microcrystalline silicon layer of 30 nm in thickness as second n-type semiconductor layer 223, and a combination of a zinc oxide film of 0.05 µm in thickness and an Ag film of 0.1 µm as second electrode 203.

As the output of power supply unit 108, a pulse-modulated AC power of 13.56 in frequency was used for depositing first p-type semiconductor layer 211 (amorphous silicon layer) and i-type amorphous silicon-base photoelectric conversion layer 212 (amorphous silicon layer). The on time of pulse modulation was 100 microseconds, the off time was 400 microseconds and the duty ratio was 20%. The density of the power supplied to cathode 102 was 0.04 W/cm² in time-averaged value.

Also, a CW AC power of 13.56 MHz in frequency was used as the output of power supply unit 108 for depositing first n-type semiconductor layer 213 (microcrystalline silicon layer), second p-type semiconductor layer 221 (microcrystalline silicon layer), i-type crystalline silicon-base photoelectric conversion layer 222 (microcrystalline silicon layer) and second n-type semiconductor layer 223 (microcrystalline silicon layer). The density of the power supplied to cathode 102 was 0.2 W/cm².

By the above forming method, the crystalline silicon-base semiconductor layers and amorphous silicon-base semiconductor layers were formed in the same plasma reaction chamber 101 by the plasma CVD method. Also, the deposition speed could be controlled easily and the uniform plasma could be generated in the step of forming the amorphous silicon-base semiconductor layer. The silicon-base thin film photoelectric conversion element having good characteristics could be manufactured by the above forming method.

Although the present invention has been described and illustrated in detail, it is clearly understood that the same is by way of illustration and example only and is not to be taken by way of limitation, the scope of the present invention being interpreted by the terms of the appended claims.

## Claims

1. A plasma processing apparatus comprising:
a plasma reaction chamber;
a first cathode-anode pair arranged inside said plasma reaction chamber, and including a first cathode; and
a first power supply unit switching a first output power between a CW AC power and a pulse-modulated AC power, and supplying said first output power to said first cathode.

2. The plasma processing apparatus according to claim 1, further comprising:
a gas pressure varying unit capable of varying a gas pressure in said plasma reaction chamber.

3. The plasma processing apparatus according to claim 1, wherein
said first power supply unit includes:
a power output unit supplying said CW AC power, and
a modulation unit performing pulse modulation on said CW AC power supplied from said power output unit when said pulse-modulated AC power is to be supplied as said first output power, and stopping said pulse modulation to pass said CW AC power when said CW AC power is to be supplied as said first output power.

4. The plasma processing apparatus according to claim 1, wherein
said first power supply unit includes:
a CW power output unit supplying said CW AC power,
a pulse power output unit supplying said pulse-modulated AC power, and
a switching unit switching said first output voltage between the output of said CW power output unit and the output of said pulse power output unit.

5. The plasma processing apparatus according to claim 1, further comprising:
a second cathode-anode pair arranged in said plasma reaction chamber and including a second cathode.

6. The plasma processing apparatus according to claim 5, further comprising:
an impedance matching circuit performing impedance matching between said first cathode-anode pair and said first power supply unit, and performing impedance matching between said second cathode-anode pair and said first power supply unit.

7. The plasma processing apparatus according to claim 5, further comprising:
a first impedance matching circuit performing impedance matching between the first cathode-anode pair and said first power supply unit;
a second power supply unit switching a second output power between the CW AC power and the pulse-modulated AC power, and supplying said second output power to said second cathode; and
a second impedance matching circuit performing impedance matching between said second cathode-anode pair and said second power supply unit.

8. The plasma processing apparatus according to claim 1, wherein
said plasma processing apparatus is an apparatus of manufacturing a silicon-base thin film photoelectric conversion element including at least an i-type amorphous silicon-base photoelectric conversion layer and an i-type crystalline silicon-base photoelectric conversion layer, and
said modulation unit outputs said pulse-modulated AC power when said i-type amorphous silicon-base photoelectric conversion layer is to be formed, and outputs said CW AC power when said i-type crystalline silicon-base photoelectric conversion layer is to be formed.

9. A plasma processing method performing at least two kinds of plasma processing in a common plasma reaction chamber, and comprising the steps of:
performing first plasma processing by using a CW AC power as a power for the plasma processing;
performing second plasma processing by using a pulse-modulated AC power as a power for said plasma processing; and
switching said power for the plasma processing between said CW AC power and said pulse-modulated AC power.

10. The plasma processing method according to claim 9, wherein
a discharge start voltage in said second plasma processing is set higher than a discharge start voltage in said first plasma processing.

11. The plasma processing method according to claim 9, wherein
a cathode-anode pair is arranged in said plasma reaction chamber, and
an inter-electrode distance in said cathode-anode pair is uniform in said first and second plasma processing.

12. The plasma processing method according to claim 9, wherein
a gas pressure in said plasma reaction chamber in said first plasma processing is different from that in said second plasma processing

13. The plasma processing method according to claim 9, wherein
a gas supplied into said plasma reaction chamber and decomposed in said first plasma processing is ionized more easily than a gas supplied into said plasma reaction chamber and decomposed in said second plasma processing when the voltage is constant in magnitude.

14. The plasma processing method according to claim 9, wherein said first plasma processing is film deposition processing performed by a plasma CVD method, and
said second plasma processing is plasma etching processing.

15. The plasma processing method according to claim 14, wherein
said plasma etching processing etches a film adhered to an inner wall of said plasma reaction chamber due to said deposition processing.

16. The plasma processing method according to claim 15, wherein
said plasma processing method is a method forming an photoelectric conversion element including a plurality of semiconductor layers, and
said deposition processing is processing forming at least one of said plurality of semiconductor layers.

17. The plasma processing method according to claim 9, wherein
said first plasma processing and said second plasma processing are steps forming a semiconductor film by a plasma CVD method.

18. The plasma processing method according to claim 9, wherein
said plasma processing method is a method forming a photoelectric conversion element including a crystalline silicon-base photoelectric conversion layer and an amorphous silicon-base photoelectric conversion layer,
said first plasma processing is processing forming said crystalline silicon-base photoelectric conversion layer by a plasma CVD method, and
said second plasma processing is processing forming said amorphous silicon-base photoelectric conversion layer by the plasma CVD method.

19. The plasma processing method according to claim 18, further comprising:
a step of etching a film adhered to an inner wall of said plasma reaction chamber by using a pulse-modulated AC power, after said crystalline silicon-base photoelectric conversion layer and said amorphous silicon-base photoelectric conversion layer are formed.

20. The plasma processing method according to claim 18, wherein
said crystalline silicon-base photoelectric conversion layer is an i-type crystalline silicon-base photoelectric conversion layer, and
said amorphous silicon-base photoelectric conversion layer is an i-type amorphous silicon-base photoelectric conversion layer.

21. The plasma processing method according to claim 20, wherein
a cathode-anode pair is arranged in said plasma reaction chamber, and
an inter-electrode distance in said cathode-anode pair is uniform in said first and second plasma processing.

22. The plasma processing method according to claim 20, wherein
said photoelectric conversion element further includes:
a p-type semiconductor layer formed of an amorphous silicon-base semiconductor arranged on a light incoming side of said i-type amorphous silicon-base photoelectric conversion layer, and
a buffer layer formed of an amorphous silicon-base semiconductor arranged between said i-type amorphous silicon-base photoelectric conversion layer and said p-type semiconductor layer; and
said plasma processing method further comprises:
a step of forming said p-type semiconductor layer; and
a step of forming said buffer layer by using a pulse-modulated AC power.

23. A photoelectric conversion element manufactured by a plasma processing method performing at least two kinds of plasma processing in a common plasma reaction chamber, and comprising:
a crystalline silicon-base photoelectric conversion element formed by plasma CVD processing using a CW AC power, and
an amorphous silicon-base photoelectric conversion layer formed by plasma CVD processing using a pulse-modulated AC power.
